# EUROPÄISCHE PATENTSCHRIFT

(11) **EP 3 690 594 B1**
(45) Veröffentlichungstag und Bekanntmachung des Hinweises auf die Patenterteilung: **30.12.2020**
(21) Anmeldenummer: 20165800.2
(22) Anmeldetag: 22.03.2016
(51) Int. Cl.: G05D 23/19, H05K 7/20

(54) **REGELUNGSVERFAHREN FÜR EIN SCHALTSCHRANKKÜHLGERÄT**
CONTROL METHOD FOR A SWITCHGEAR COOLER
PROCÉDÉ DE RÉGULATION POUR UN APPAREIL DE RÉFRIGÉRATION D'ARMOIRE DE DISTRIBUTION

(30) Priorität: 30.03.2015 DE 102015104843
(43) Veröffentlichungstag der Anmeldung: 05.08.2020
(62) Dokumentnummer(n) der früheren Anmeldung(en) nach Art. 76 EPÜ: 16720702.6 / 3 278 190
(73) Patentinhaber: Rittal GmbH & Co. KG, 35745 Herborn (DE)
(72) Erfinder: Rosenthal, Daniel, 57072 Siegen (DE)
(74) Vertreter: Angerhausen, Christoph

(56) Entgegenhaltungen:
- DE-A1- 3 207 261
- GB-A- 2 329 012
- US-A1- 2008 221 713

## Beschreibung

Die Erfindung betrifft ein Regelungsverfahren für ein Schaltschrankkühlgerät, das einen ersten Kältemittelkreislauf mit einer Kältemaschine und einen davon getrennten zweiten Kältemittelkreislauf mit einer Heatpipe-Anordnung aufweist, wobei Umgebungsluft zur Wärmeableitung durch einen Außenkreis des Schaltschrankkühlgeräts und zu kühlende Luft aus dem Innern eines zu kühlenden Schaltschranks durch einen Innenkreis des Schaltschrankkühlgeräts geleitet wird. Eine Schaltschrankanordnung mit einem derartigen Schaltschrankkühlgerät ist beispielsweise aus der DE 10 2012 108 110 A1 bekannt.

Um solche Schaltschrankkühlgeräte energieeffizient betreiben zu können, ist es zu jedem Betriebspunkt erforderlich, aus den beiden Kältemittelkreisläufen denjenigen auszuwählen, welcher die erforderliche Kühlleistung effizienter bereitstellen kann. Dazu ist jedoch zum einen Kenntnis über den Kühlleistungsbedarf erforderlich, das heißt diejenige Kühlleistung, welche benötigt wird, um die Schaltschrankinnentemperatur auf einer Solltemperatur zu halten. Zum anderen ist es erforderlich, zu dem jeweiligen Betriebspunkt den Wirkungsgrad bzw. einen repräsentativen Energieeffizienzwert zu bestimmen, welchen der jeweilige Kältemittelkreislauf aufweist, wenn er den aktuell erforderlichen Kühlleistungsbedarf bereitstellen soll.

Bei aus dem Stand der Technik bekannten Schaltschrankkühlgeräten, welche beispielsweise allein auf dem Prinzip der Kältemaschine beruhen, ist es in Anbetracht der Unkenntnis über den Kühlleistungsbedarf und die Energieeffizienz der Kältemaschine üblich, die Kältemaschine unabhängig vom Kühlleistungsbedarf bei einer vorgegebenen Drehzahl, beispielsweise bei einer Höchstdrehzahl des Verdichters zu betreiben, bei welcher die Kältemaschine im Mittel über ihre Bauteillebensdauer ihren höchsten Wirkungsgrad haben soll. Des Weiteren wird durch den Betrieb bei einer Höchstdrehzahl des Verdichters sichergestellt, dass auch Kühlleistungsbedarfsspitzen abgefangen werden können. Im Umkehrschluss hat der Betrieb der Kältemaschine bei hohen Verdichterleistungen jedoch zur Folge, dass die Kältemaschine im Taktbetrieb betrieben werden muss, bei dem die Schaltschrankinnentemperatur eine Hysterese zwischen einer oberen und einer unteren Grenztemperatur um die Solltemperatur herum ausführt. Dies ist jedoch energetisch nachteilig, insbesondere im Vergleich zu der Idealsituation, bei der mit Hilfe der Kältemaschine gerade eine Kühlleistung bereitgestellt wird, welche mehr oder weniger ganau dem Kühlleistungsbedarf entspricht.

Es ist die Aufgabe der Erfindung, ein Regelungsverfahren für ein Schaltschrankkühlgerät mit einer Kältemaschine und einer Heatpipe-Anordnung bereitzustellen, welches es erlaubt, zu jedem Betriebspunkt eine nach Energieeffizienzgesichtspunkten optimale Auswahl zwischen dem ersten und dem zweiten Kältemittelkreislauf zu ermöglichen.

Diese Aufgabe wird erfindungsgemäß durch ein Verfahren mit den Merkmalen des Anspruchs 1 gelöst.

Demgemäß weist das erfindungsgemäße Verfahren die Schritte auf:
- kontinuierliches oder periodisches Messen einer aktuellen Schaltschrankinnentemperatur *Tᵢ* und Festlegen einer Solltemperatur für die Schaltschrankinnentemperatur *Tᵢ,* wobei die aktuelle Schaltschrankinnentemperatur *Tᵢ* und die Solltemperatur Eingangssignale eines Reglers zur Ansteuerung des Schaltschrankkühlgeräts bilden, und wobei der Regler in Abhängigkeit der Eingangssignale ein Steuersignal für die Festlegung von Stellgrößen der Kältemaschine ausgibt;
- Festlegen des Reglersteuersignals als eine Messgröße, die proportional zum jeweils aktuellen Kühlleistungsbedarf *P* ist, wobei der Kühlleistungsbedarf diejenige Kühlleistung ist, die erforderlich ist, um die Schaltschrankinnen-temperatur *Tᵢ* konstant auf der Solltemperatur zu halten;
- kontinuierlich oder periodisches Messen der Schaltschrankumgebungstemperatur *Tᵤ* und Bestimmen jeweils einer Energieeffizienz oder einer repräsentativen Größe für den ersten und den zweiten Kühlmittelkreislauf bei den gemessenen Temperaturen *Tᵢ, Tᵤ* und der Solltemperatur unter Verwendung von Kühlgerätekenndaten für den ersten und den zweiten Kühlmittelkreislauf, für die beiden Fälle, dass der Kühlleistungsbedarf entweder mit dem ersten oder mit dem zweiten Kühlmittelkreislauf bereitgestellt werden soll; und
- Auswählen und in Betrieb nehmen desjenigen der beiden Kühlmittelkreisläufe, der den Kühlleistungsbedarf mit der besseren Energieeffizienz bereitstellen kann.

Der Erfindung liegt somit die Idee zugrunde, als zusätzliche Messgröße die Schaltschrankumgebungstemperatur zu bestimmen, um aus dem Temperaturpaar von Schaltschrankinnentemperatur und Schaltschaltumgebungstemperatur in Kenntnis eines geschätzten Kühlleistungsbedarfs eine optimale Auswahl zwischen den beiden Kältemittelkreisläufen zu treffen. Die Abschätzung des Kühlleistungsbedarfs beruht auf der Erkenntnis, dass der Regler Steuersignale für die Festlegung von Stellgrößen der Kältemaschine zur Ansteuerung des Schaltschrankkühlgeräts in Abhängigkeit von Solltemperatur und Schaltschrankinnentemperatur ausgibt, die eine Proportionalität zum Kühlleistungsbedarf aufweisen. Wenn der Regler beispielsweise ein Regler zur Steuerung einer Kältemaschine ist, beispielsweise ein PID-Regler, so umfasst der Regler beispielsweise zumindest eine Stellgröße für die Drehzahl der Lüfter der Kältemaschine für den Transport der Luft im Innenkreislauf bzw. im Außenkreislauf. Das Steuersignal des Reglers wird weiterhin eine Stellgröße aufweisen, welche die Verdichterdrehzahl vorgeben soll. Unter der Annahme, dass die Verdichterdrehzahl und die Lüfterdrehzahlen proportional zum Kühlleistungsbedarf sind, kann folglich aus dem Steuersignal des Reglers ein Kühlleistungsbedarf abgeleitet werden. Zur Umsetzung der Erfindung ist es nicht erforderlich, dass eine quantitativ exakte Größe für den Kühlleistungsbedarf bestimmt wird. Vielmehr ist eine Abschätzung des Kühlleistungsbedarfs ausreichend.

In Kenntnis des abgeschätzten Kühlleistungsbedarfs sowie der Temperaturdifferenz zwischen Schaltschrankinnentemperatur und Schaltschrankumgebungstemperatur kann folglich eine Abschätzung erfolgen, mit Hilfe welches der beiden Kältemittelkreisläufe der ermittelte Kühlleistungsbedarf energieeffizienter bereitgestellt werden kann.

Bei einer Ausführungsform der Erfindung ist es vorgesehen, dass die Stellgrößen, insbesondere die Lüfterdrehzahlen und die Verdichterdrehzahl, für den ersten und den zweiten Kühlmittelkreislauf über die Gerätekenndaten einer bestimmten erwarteten Kühlleistung und Energieeffizienz zugeordnet sind, und wobei das in Betrieb nehmen unter Anwendung der Gerätekenndaten derart erfolgt, dass der ausgewählte Kühlmittelkreislauf eine Kühlleistung erbringt, die im Wesentlichen dem Kühlleistungsbedarf entspricht.

Bei einer weiteren Ausführungsform der Erfindung ist der Regler ein PID-Regler für eine Kältemaschine, dessen Steuersignal in Abhängigkeit von der Solltemperatur und der Schaltschrankinnentemperatur *Tᵢ* zumindest eine Stellgröße für mindestens eine Lüfterdrehzahl für den Lufttransport durch einen Innen- oder Außenkreis des Kühlgeräts und eine Verdichterdrehzahl ausgibt.

Dabei kann vorgesehen sein, dass die Stellgrößen als proportional zum Kühlleistungsbedarf angenommen und mittels einer Übertragungsfunktion, die auch nur ein Multiplikator oder Umrechnungsfaktor sein kann, in einen Näherungswert für den Kühlleistungsbedarf übertragen werden.

Bei noch einer anderen Ausführungsform der Erfindung weist das Verfahren weiterhin das Abschätzen einer maximalen und/oder einer minimalen Kühlleistung für den ersten und/oder den zweiten Kühlmittelkreislauf bei den gemessenen Temperaturen *Tᵢ, Tᵤ* und unter Verwendung von Gerätekenndaten auf.

Die Gerätekenndaten können in einer Datenbank hinterlegt sein und die erbrachte Kühlleistung bei gegebener Schaltschrankinnentemperatur und gegebener Schaltschrankumgebungstemperatur mit einer erwarteten Energieeffizienz in Relation setzen.

Dabei kann vorgesehen sein, dass das Abschätzen der maximalen und/oder minimalen Kühlleistung für den ersten und/oder den zweiten Kühlmittelkreislauf unter der Randbedingung erfolgt, dass der jeweils andere Kühlmittelkreislauf die jeweilige maximale und/oder minimale Kühlleistung nicht mit einer besseren Energieeffizienz bereitstellen kann.

Der abgeschätzte Kühlleistungsbedarf kann darüber hinaus auch dazu verwendet werden, um den Taktbetrieb eines eine Kältemaschine aufweisenden Kältemittelkreislaufs zu optimieren. Dazu ist bei einer Ausführungsform der Erfindung vorgesehen, dass das Verfahren weiterhin für den Taktbetrieb der Kältemaschine das Bestimmen einer Kühlhysterese mit einer oberen und einer unteren Grenztemperatur aufweist, die um die Solltemperatur liegen, derart, dass die Abschaltzeit der Kältemaschine, während der sich die Schaltschrankinnentemperatur *Tᵢ* von der unteren Grenztemperatur auf die obere Grenztemperatur erwärmt, mindestens einer Mindestabschaltzeit des Verdichters zwischen aufeinander folgenden Aktivphasen entspricht, wobei sich die Abschaltzeit gemäß ${t}_{Ab} = \frac{C ∗ Δ T}{P}$ abschätzen lässt, wobei C die vorgegebene, geschätzte oder experimentell ermittelte Wärmekapazität des Schaltschranks ist, der die zu kühlende Luft aufgenommen hat, Δ*T* die Temperaturdifferenz zwischen dem oberen und dem unteren Grenzwert ist, und *P* der abgeschätzte Kühlleistungsbedarf ist.

Gemäß einem anderen Aspekt der Erfindung wird der anhand des Reglersteuersignals abgeschätzte Kühlleistungsbedarf nicht zwingend dazu verwendet, um das Schaltschrankkühlgerät energieoptimiert zu betreiben. Vielmehr kann auch vorgesehen sein, dass das als eine Messgröße, die proportional zum jeweils aktuellen Kühlleistungsbedarf ist, festgelegte Reglersteuersignal auf einer Anzeige ausgegeben oder für weitergehende Funktionen in der Schaltschrank- oder Rechenzentrumsklimatisierung verwendet wird.

Weitere Einzelheiten der Erfindung werden anhand der nachstehenden Figuren erläutert. Dabei zeigt:
- Figur 1: schematisch eine Regelschleife gemäß dem Stand der Technik;
- Figur 2: schematisch eine Regelschleife, gemäß einer ersten Ausführungsform der Erfindung; und
- Figur 3: schematisch eine Regelschleife gemäß einer anderen Ausführungsform der Erfindung.

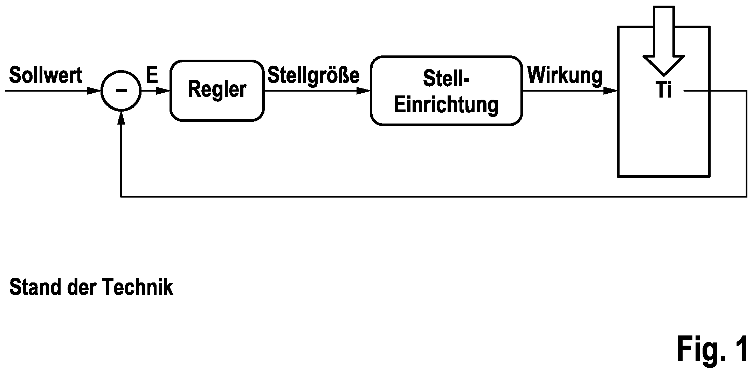

Bei der in Figur 1 dargestellten Regelschleife gemäß dem Stand der Technik wird ein Sollwert für die Schaltschrankinnentemperatur als Eingangssignal einem Regler bereitgestellt. Der Regler kann beispielsweise ein PID-Regler sein. Entsprechend der Kühltechnologie, welche zur Klimatisierung des Schaltschranks verwendet wird, ermittelt der PID-Regler, beispielsweise anhand von den Kältemittelkreislauf charakterisierenden Gerätekenndaten, Stellgrößen, die in Form eines Stellsignals an die Stelleinrichtung weitergeleitet werden. Die Stelleinrichtung kann beispielsweise eine Kältemaschine oder eine Heatpipe-Anordnung sein.

Im Falle einer Kältemaschine können die Stellgrößen beispielsweise eine Verdichterdrehzahl oder mindestens eine Lüfterdrehzahl für mindestens einen Lüfter sein. Der Verdichter und die Lüfter sind dabei hinsichtlich ihrer Drehzahl einstellbar. Anhand der dem Regler vorliegenden Gerätekenndaten bestimmt der Regler die Stellgrößen derart, dass bei gegebenen Temperatursollwert und gemessener Schaltschrankinnentemperatur *Tᵢ* die Stelleinrichtung so voreingestellt wird, dass sich der Differenzwert aus Sollwert und Schaltschrankinnentemperatur verkleinert. Ist die Stelleinrichtung eine Kältemaschine, so kann der Regler weiterhin darauf ausgelegt sein, die Kältemaschine in einem Taktbetrieb zu betreiben, bei der die Schaltschrankinnentemperatur eine Hysterese zwischen einem oberen und einem unteren Grenzwert um den Sollwert ausführt. Grundsätzlich erfolgt somit bei aus dem Stand der Technik bekannten Regelungsverfahren die Auswahl der Stellgrößen unabhängig von dem tatsächlichen Kühlleistungsbedarf, welcher erforderlich wäre, um die Schaltschrankinnentemperatur auf dem Sollwert zu halten.

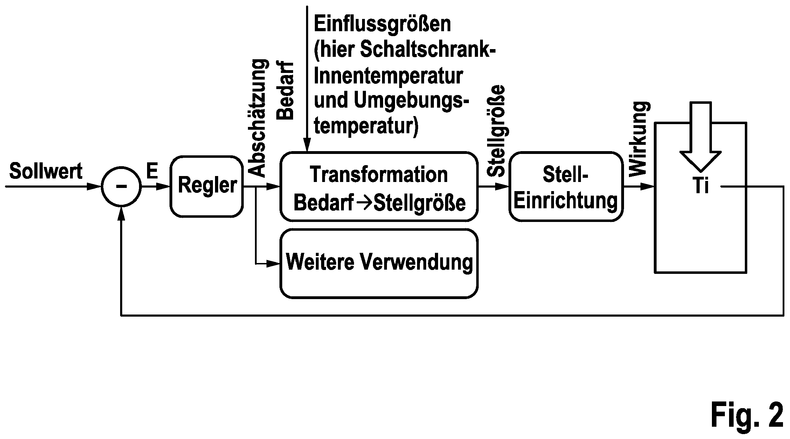

Die Figur 2 zeigt eine Regelschleife gemäß einer ersten Ausführungsform der Erfindung. Auch bei dieser wird das Differenzsignal aus Sollwert und Schaltschrankinnentemperatur *Tᵢ* als Eingangssignal *E* einem Regler zugeführt. Wie bei den aus dem Stand der Technik bekannten Regelungsverfahren kann auch der Regler bei der Ausführungsform gemäß Figur 2 ein PID-Regler sein. Erfindungswesentlich ist nunmehr, dass das Ausgangssignal des Reglers nicht unmittelbar als Stellgröße verwendet wird, welche auf die Stelleinrichtung wirkt, sondern als ein Signal interpretiert wird, das proportional zum Kühlleistungsbedarf ist. Diese Annahme ist insofern berechtigt, als dass, wie mit Bezug auf Figur 1 beschrieben, die von dem Regler ausgegebenen Stellgrößen, beispielsweise die Verdichter- oder Lüfterdrehzahlen, proportional zum Kühlleistungsbedarf sind. In Kenntnis dieses geschätzten Kühlleistungsbedarfs sowie der Temperaturdifferenz zwischen Schaltschrankinnentemperatur und Umgebungstemperatur kann beispielsweise anhand von Kühlgerätekenndaten bestimmt werden, welcher der beiden Kältemittelkreisläufe den abgeschätzten Kühlleistungsbedarf mit der höheren Energieeffizienz bereitstellen kann.

Bei der in der Figur 2 dargestellten Ausführungsform kann die Stelleinrichtung beispielsweise aus einem Schaltschrankkühlgerät bestehen, das neben einer Kältemaschine eine Heatpipe-Anordnung aufweist, die alternativ für die Bereitstellung eines Kühlleistungsbedarfs eingesetzt werden können. Je nachdem, ob die Abschätzung der Energieeffizienz von Kältemaschine und Heatpipe-Anordnung ergeben hat, dass bei den gegebenen Umständen (Kühlleistungsbedarf, Schaltschrankinnentemperatur, Schaltschrankumgebungstemperatur) die ein oder die andere Kühltechnologie den Kühlleistungsbedarf mit der besseren Energieeffizienz bereitstellen kann, wird die energieeffizientere Kühlmethode für die Kühlung der Schaltschrankluft ausgewählt, indem entsprechende Stellgrößen an die Stelleinrichtung weitergeleitet werden.

Darüber hinaus ist es denkbar, dass der abgeschätzte Kühlleistungsbedarf zur weiteren Verwendung herangezogen wird. Wie bereits oben beschrieben, kann der abgeschätzte Kühlleistungsbedarf auch dazu verwendet werden, um die Hysterese einer Kältemaschine dahingehend zu optimieren, dass die Abschaltzeit zwischen den Aktivphasen der Kältemaschine gerade einer Mindestabschaltzeit des Verdichters der Kältemaschine entspricht, welche erforderlich ist, um die dauerhafte Betriebssicherheit der Kältemaschine zu gewährleisten.

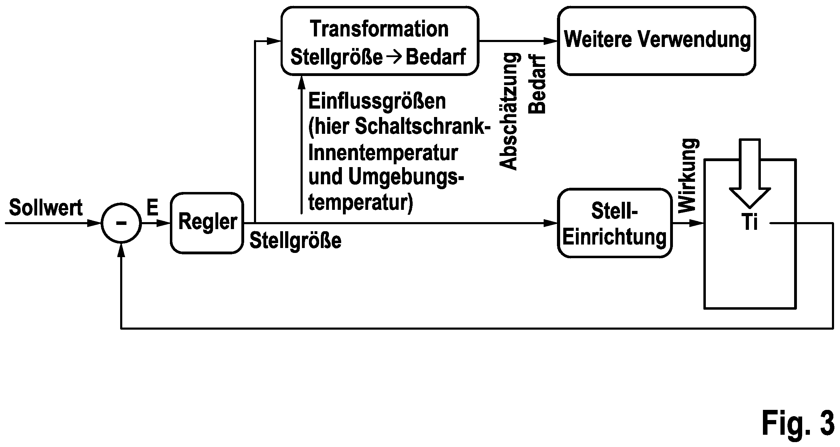

Bei der in Figur 3 dargestellten Ausführungsform entspricht die Regelschleife, soweit die Kühlung des Schaltschranks betroffen ist, derjenigen, die in Figur 1 dargestellt und aus dem Stand der Technik bekannt ist. Bei der Ausführungsform gemäß Figur 3 wird jedoch das Ausgangssignal des Reglers, nämlich die an die Stelleinrichtung ausgegebenen Stellgrößen, wiederum in der mit Bezug auf Figur 2 beschriebenen Weise zur Abschätzung des Kühlleistungsbedarfs herangezogen, wozu wiederum als weitere Einflussgrößen die Schaltschrankinnentemperatur und die Schaltschrankumgebungstemperatur mit einfließen. Dieser abgeschätzte Kühlleistungsbedarf kann auf vielfältige Weise bei der Optimierung des Schaltschrankbetriebs oder des Betriebs eines Rechenzentrums, in dem mehrere Schaltschränke angeordnet sind und das ein Energiemanagement aufweist, verwendet werden. Wie bereits erwähnt, kann mit Hilfe des abgeschätzten Kühlleistungsbedarfs beispielsweise die Hysterese einer Kältemaschine die im Taktbetrieb läuft, insoweit optimiert werden, dass die Abschaltdauer zwischen einzelnen Aktivphasen des Verdichters mindestens einer Mindestabschaltzeit des Verdichters entspricht.

## Patentansprüche

1. Regelungsverfahren für ein Schaltschrankkühlgerät, das einen ersten Kältemittelkreislauf mit einer Kältemaschine und einen davon getrennten zweiten Kältemittelkreislauf mit einer Heatpipe-Anordnung aufweist, wobei Umgebungsluft zu Wärmeableitung durch einen Außenkreis des Schaltschrankkühlgeräts und zu kühlende Luft aus dem Innern eines zu kühlenden Schaltschranks durch einen Innenkreis des Schaltschranckühlgeräts geleitet wird, wobei das Verfahren die Schritte aufweist:
- kontinuierliches oder periodisches Messen einer aktuellen Schaltschrankinnentemperatur (*Tᵢ*) und Festlegen einer Solltemperatur für die Schaltschrankinnentemperatur (*Tᵢ*), wobei die aktuelle Schaltschrankinnentemperatur (*Tᵢ*) und die Solltemperatur Eingangssignale eines Reglers zur Ansteuerung des Schaltschrankkühlgeräts bilden, und wobei der Regler in Abhängigkeit der Eingangssignale ein Steuersignal für die Festlegung von Stellgrößen der Kältemaschine ausgibt;
- Festlegen des Reglersteuersignals als eine Messgröße, die proportional zum jeweils aktuellen Kühlleistungsbedarf (*P*) ist, wobei der Kühlleistungsbedarf diejenige Kühlleistung ist, die erforderlich ist, um die Schaltschrankinnentemperatur (*Tᵢ*) konstant auf der Solltemperatur zu halten;
- Ausgeben der Messgröße, die proportional zum jeweils aktuellen Kühlleistungsbedarf (*P*) ist auf einer Anzeige oder an eine Regel- und Steuereinheit für die Schaltschrankklimatisierung für die Weiterverwendung,
wobei die Weiterverwendung für den Taktbetrieb der Kältemaschine das Bestimmen einer Kühlhysterese mit einer oberen und einer unteren Grenztemperatur aufweist, die um die Solltemperatur liegen, derart, dass die Abschaltzeit der Kältemaschine, während der sich die Schaltschrankinnentemperatur (*Tᵢ*) von der unteren Grenztemperatur auf die obere Grenztemperatur erwärmt, mindestens einer Mindestabschaltzeit des Verdichters zwischen aufeinander folgenden Aktivphasen entspricht,
wobei sich die Abschaltzeit gemäß ${t}_{Ab} = \frac{C ∗ Δ T}{P}$ abschätzen lässt, wobei C die vorgegebene, geschätzte oder experimentell ermittelte Wärmekapazität des Schaltschranks ist, der die zu kühlende Luft aufgenommen hat, *ΔT* die Temperaturdifferenz zwischen dem oberen und dem unteren Grenzwert ist, und *P* der abgeschätzte Kühlleistungsbedarf ist.

## Claims

1. A control method for a switch cabinet refrigeration apparatus comprising a first refrigerant circuit including a refrigerating machine and a second refrigerant circuit separate therefrom including a heat pipe arrangement, wherein ambient air is passed through an outer circuit of the switch cabinet refrigeration apparatus for heat dissipation and air to be cooled from inside a switch cabinet to be cooled is passed through an inner circuit of the switch cabinet refrigeration apparatus, the method comprising the steps
- continuous or periodic measurement of a current switch cabinet internal temperature (*Tᵢ*) and determination of a setpoint temperature for the switch cabinet internal temperature (*Tᵢ*), wherein the current switch cabinet internal temperature (*Tᵢ*) and the setpoint temperature form input signals of a controller for actuating the switch cabinet cooling device, and wherein the controller outputs a control signal for determining manipulated variables of the refrigerating machine as a function of the input signals;
- defining the controller control signal as a measured variable which is proportional to the respective current cooling power requirement (P), wherein the cooling power requirement is that cooling power which is required to keep the switch cabinet internal temperature (*Tᵢ*) constantly at the setpoint temperature;
- output of the measured quantity, which is proportional to the respective current cooling power requirement (P), on a display or to a regulation and control unit for the switch cabinet air conditioning for further use,
wherein the further use for the cycle operation of the refrigerating machine comprises determining a cooling hysteresis with an upper and a lower limit temperature which lie around the setpoint temperature in such a way that the switch-off time of the refrigerating machine, during which the switch cabinet internal temperature (*Tᵢ*) heats up from the lower limit temperature to the upper limit temperature, corresponds to at least a minimum switch-off time of the compressor between successive active phases,
where the switch-off time can be estimated according to ${t}_{Ab} = \frac{C ∗ Δ T}{P} ,$ where C is the specified, estimated or experimentally determined heat capacity of the switch cabinet that has absorbed the air to be cooled, ΔT is the temperature difference between the upper and lower limit values, and P is the estimated cooling capacity requirement.

## Revendications

1. Procédé de régulation pour un appareil de refroidissement d'armoire de distribution qui comporte un premier circuit d'agent réfrigérant avec une machine frigorifique et un deuxième circuit d'agent réfrigérant qui en est séparé, avec un ensemble caloduc, de l'air ambiant étant conduit pour la dissipation de chaleur à travers une circulation extérieure de l'appareil de refroidissement d'armoire de distribution, et de l'air à refroidir étant guidé à partir de l'intérieur d'une armoire de distribution à refroidir à travers une circulation intérieure de l'appareil de refroidissement d'armoire de distribution, le procédé comportant les étapes :
- mesurage continu ou périodique d'une température intérieure d'armoire de distribution (*T*ᵢ) instantanée et détermination d'une température de consigne pour la température intérieure d'armoire de distribution (*T*ᵢ), la température intérieure d'armoire de distribution (*T*ᵢ) instantanée et la température de consigne formant des signaux d'entrée d'un régulateur destinés au pilotage de l'appareil de refroidissement d'armoire de distribution, et le régulateur délivrant, en fonction des signaux d'entrée, un signal de commande pour la détermination de grandeurs réglantes de la machine frigorifique ;
- détermination du signal de commande de régulateur en tant que grandeur de mesure qui est proportionnelle à la puissance de refroidissement requise (*P*) respectivement instantanée, la puissance de refroidissement requise étant la puissance de refroidissement qui est nécessaire pour maintenir constamment la température intérieure d'armoire de distribution (*T*ᵢ) à la température de consigne ;
- délivrance de la grandeur de mesure qui est proportionnelle à la puissance de refroidissement requise (*P*) respectivement instantanée sur un affichage ou sur une unité de régulation et de commande pour la climatisation de l'armoire de distribution pour la réutilisation,
la réutilisation pour le fonctionnement cadencé de la machine frigorifique comportant la définition d'une hystérésis de refroidissement avec une température limite supérieure et une température limite inférieure qui sont situées autour de la température de consigne de telle sorte que le temps de coupure de la machine frigorifique pendant lequel la température intérieure d'armoire de distribution (*T*ᵢ) augmente à partir de la température limite inférieure vers la température limite supérieure correspond au moins à un temps de coupure minimal du compresseur entre des phases actives qui se succèdent,
le temps de coupure pouvant être estimé selon ${t}_{Ab} = \frac{C ∗ Δ T}{P} ,$ C étant la capacité thermique prédéfinie, estimée ou déterminée expérimentalement de l'armoire de distribution qui a reçu l'air à refroidir, Δ*T* étant la différence de température entre la valeur limite supérieure et la valeur limite inférieure, et *P* étant la puissance de refroidissement requise estimée.
